# FASCICULE DE BREVET EUROPEEN

(11) **EP 2 139 038 B1**
(45) Date de publication et mention de la délivrance du brevet: **15.08.2012**
(21) Numéro de dépôt: 09305329.6
(22) Date de dépôt: 17.04.2009
(51) Int. Cl.: H01L 23/532, H01L 21/768

(54) **Architecture d'interconnections horizontales à base de nanotubes de carbone**
Aufbau von horizontalen Zwischenverbindungen auf der Basis von Kohlenstoff-Nanokanälen
Horizontal interconnection architecture based on carbon nanotubes

(30) Priorité: 25.06.2008 FR 0854213
(43) Date de publication de la demande: 30.12.2009
(73) Titulaire: Commissariat à l'Énergie Atomique et aux Énergies Alternatives, 75015 Paris (FR)
(72) Inventeur: Dijon, Jean, 38800, Champagnier (FR)
(74) Mandataire: Vuillermoz, Bruno

(56) Documents cités:
- US-A1- 2005 215 049
- US-A1- 2006 086 958
- US-A1- 2007 205 450
- US-A1- 2008 095 695

## Description

### DOMAINE DE L'INVENTION

La présente invention concerne un dispositif d'interconnexions horizontales, basé sur la croissance horizontale de nanotubes de carbone (CNT).

### ETAT ANTERIEUR DE LA TECHNIQUE

Les nanotubes de carbone constituent une solution potentielle pour réaliser des interconnections, notamment grâce à la formation de vias ou lignes d'interconnexion.

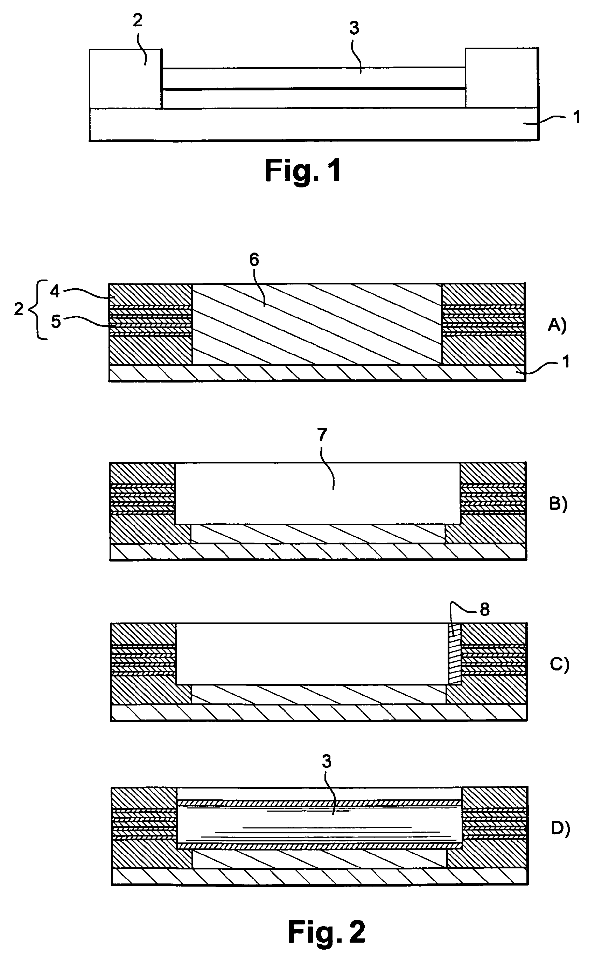

Concernant les lignes d'interconnexion, un matériau très dense, constitué d'un toron de nanotubes à une paroi (acronyme SWCNT pour l'expression anglo-saxonne «*single-walled carbon nanotube*») ou à petit nombre de parois (acronyme MWCNT pour l'expression anglo-saxonne «*multi-walled carbon nanotubes*»), est susceptible d'établir une connexion entre des plots conducteurs selon le schéma de la figure 1.

Une solution technique envisageable pour réaliser ce type de produit consiste à utiliser la croissance catalytique de nanotubes de carbone. De fait, des nanotubes de plusieurs millimètres de longueur on déjà été réalisés [1], ce qui est suffisant pour les applications envisagées.

Toutefois, des difficultés techniques pour réaliser un tel produit sont encore à surmonter:
- la localisation de la croissance de nanotubes sur les flancs de la structure ;
- le guidage des nanotubes d'un plot au plot adjacent ;
- la réalisation d'une connexion avec une très forte densité de CNT connectés électriquement.

Le dernier point apparaît comme particulièrement délicat. En effet et à ce jour, les très fortes densités de nanotubes n'ont été obtenues que sur des films isolants [2].

US 2007/0205450 décrit un procédé pour établir une connexion électrique horizontale comprenant des nanotubes de carbon entre deux plots à l'aide d'un matériau catalysant la croissance de nanotubes.

L'objectif de l'invention est donc de proposer une solution technique permettant de résoudre ces problèmes, et notamment de surmonter la difficulté de déposer une couche de catalyseur, pour initier la croissance des nanotubes, sur des parois verticales.

### EXPOSE DE L'INVENTION

La présente invention rapporte pour la première fois la possibilité d'utiliser des nanotubes de carbone pour réaliser des connexions horizontales entre des plots électriques.

Ainsi et selon un premier aspect, la présente invention concerne un dispositif qui permet d'établir une connexion électrique horizontale entre au moins deux plots électriques et qui est basé sur des nanotubes de carbone horizontaux reliant les parois verticales des plots.

De manière spécifique et en relation avec le procédé de fabrication décrit ci-après, le dispositif selon l'invention concerne des plots réalisés à l'aide d'un empilement de couches d'au moins deux matériaux, l'un catalysant la croissance des nanotubes et l'autre jouant le rôle d'espaceur entre les couches favorisant la croissance.

Ainsi, cet empilement de couches ou multicouche, qui alterne avantageusement les deux types de matériaux, assure à la fois la croissance horizontale des nanotubes de carbone, mais aussi une division nanométrique stable en température du catalyseur.

L'intérêt du multicouche catalytique est de réaliser une structure à pas nanométrique dans une direction, assurant une fragmentation stable en température de la couche de métal. Son dépôt est facile et on évite ainsi le problème de dépôt d'un catalyseur de croissance sur les flancs verticaux d'une structure.

Une autre fonction de cet empilement est d'assurer la conduction électrique. Ainsi au moins l'un des matériaux, voire les deux, sont conducteurs électriques.

Selon une caractéristique avantageuse de l'invention, le catalyseur de chacun des empilements peut se présenter sous la forme d'une couche continue ou sous forme d'une couche composée d'agrégats.

### Plusieurs agencements sont envisageables :

Selon un premier mode de réalisation, c'est le matériau catalyseur qui est conducteur électrique. Il s'agit avantageusement d'un métal, notamment du fer (Fe), ou d'un alliage métallique.

En combinaison avec ce matériau catalyseur conducteur électrique, deux options sont possibles :

Le matériau jouant le rôle d'espaceur peut être un matériau diélectrique. Il s'agit avantageusement d'un oxyde, tel que l'alumine (oxyde d'aluminium), la silice (oxyde de silicium) ou l'oxyde de magnésium (MgO).

Alternativement, le matériau jouant le rôle d'espaceur est également conducteur électrique. Il s'agit avantageusement d'un semi-conducteur, tel que le silicium (Si), ou d'un oxyde conducteur tel que l'ITO (oxyde d'indium dopé à l'étain) ou l'oxyde de ruthénium (RuO).

Tous ces matériaux sont favorables pour la croissance des nanotubes. En outre, la continuité électrique entre les torons de nanotubes est assurée par les couches de catalyseur enterrées.

Selon un autre mode de réalisation, le matériau catalyseur est un matériau diélectrique, avantageusement un oxyde de fer isolant, et le matériau jouant le rôle d'espaceur est conducteur électrique, avantageusement un métal tel que le fer (Fe), le palladium (Pd) et le titane (Ti), ou un oxyde conducteur tel que l'ITO (oxyde d'indium dopé à l'étain) ou l'oxyde de ruthénium (RuO).

De manière avantageuse, les plots ont une section transversale en forme de losange. Ainsi, il est possible d'obtenir une densité de nanotubes indépendante de la largeur des tranchées. En effet, la largeur de la connexion dépend ainsi uniquement de la position du flan de la tranchée par rapport à la pointe du losange et non de la taille du plot. De ce fait, on peut réaliser des matrices de plots standards et obtenir la finesse de la connexion uniquement en positionnant à la bonne distance de la pointe le bout de la tranchée, au moment de la gravure de cette tranchée.

De manière privilégiée, les plots peuvent en outre contenir, dans leur partie centrale, une traversée verticale conductrice électrique, avantageusement réalisée à l'aide d'un métal tel que le cuivre.

Un autre aspect de l'invention concerne le procédé permettant la réalisation d'un tel dispositif de connexion horizontale à base de nanotubes de carbone.

Ce procédé comporte les étapes essentielles suivantes :
■ dépôt sur un substrat d'un empilement de couches d'au moins deux matériaux comme définis précédemment ;
■ définition de plots à partir de cet empilement ;
■ immersion de ces plots dans une matrice diélectrique ;
■ formation de tranchées dans la matrice diélectrique pour définir les lignes d'interconnexion entre les plots et pour guider la croissance des nanotubes entre les plots ;
■ croissance des nanotubes de carbone dans les tranchées réalisant ainsi des connexions horizontales entre les plots.

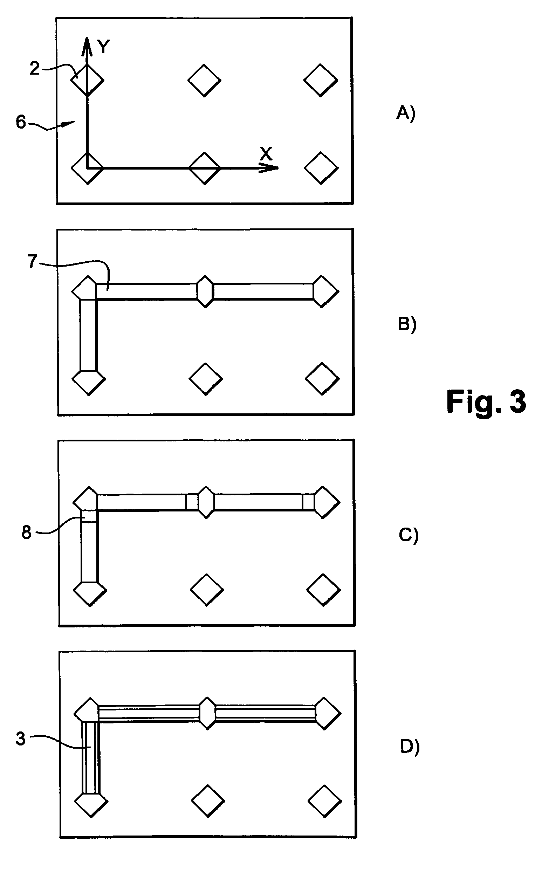

Les étapes essentielles du procédé selon l'invention sont schématisées à la figure 2, qui constitue une vue en section, et à la figure 3, qui correspond à une vue de dessus.
Grâce à cet empilement de couches assurant à la fois la fonction de catalyseur et de conduction électrique, la technologie à mettre en oeuvre est grandement simplifiée et se limite à des dépôts horizontaux.

Les plots peuvent être définis par gravure sèche ou humide et une résine doit être préalablement déposée sur l'empilement pour réaliser la lithographie des plots.

Des couches sacrificielles peuvent être déposées sous l'empilement, voire au dessus, avant le dépôt de la résine pour faciliter la réalisation du métal de contact.

La matrice isolante (ou diélectrique) dans laquelle sont noyés les plots est avantageusement constituée d'un oxyde, d'un nitrure ou d'un matériau à faible constante diélectrique. Il s'agit par exemple d'alumine.

Ensuite dans le but de connecter deux points, on vient ouvrir des tranchées dans l'isolant et on met ainsi à nu le multicouche catalytique qui devient actif pour la croissance de la connexion. On fait alors pousser les nanotubes dans les zones ouvertes qui guident les nanotubes.

Selon un mode de réalisation privilégié, une couche d'un matériau de contact inhibant la croissance des nanotubes et favorisant le contact électrique, par exemple du palladium, est déposée sur au moins l'une des faces verticales des plots, avant la croissance des nanotubes.

Avantageusement, il s'agit des faces des plots en regard d'une face de croissance. Ainsi, au cours de leur croissance, les nanotubes viennent se connecter sur la surface en regard et établissent un auto-contact sur le plot en vis-à-vis du plot de croissance.

Par conséquent, dans le dispositif final, au moins un des deux plots à connecter est recouvert, au niveau de sa zone de contact avec les nanotubes de carbone, dudit matériau.

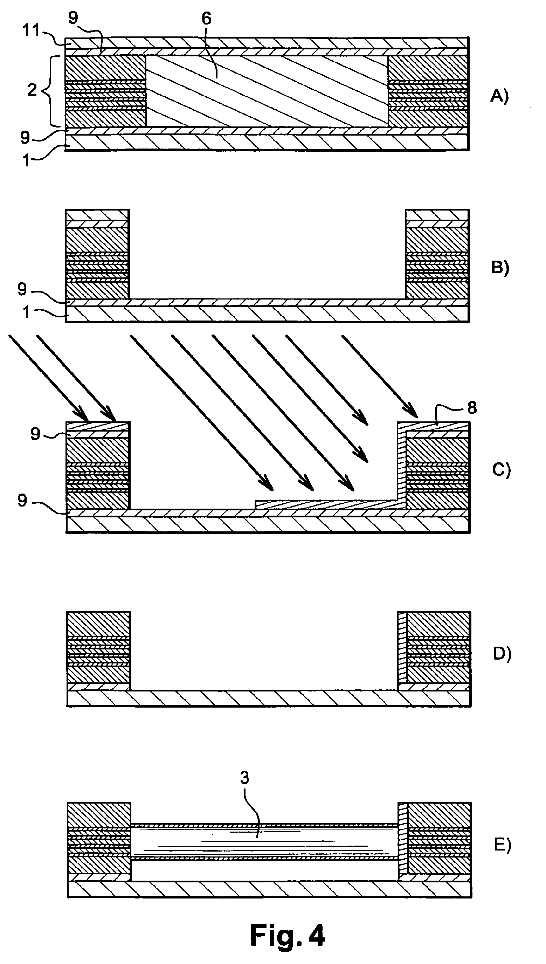

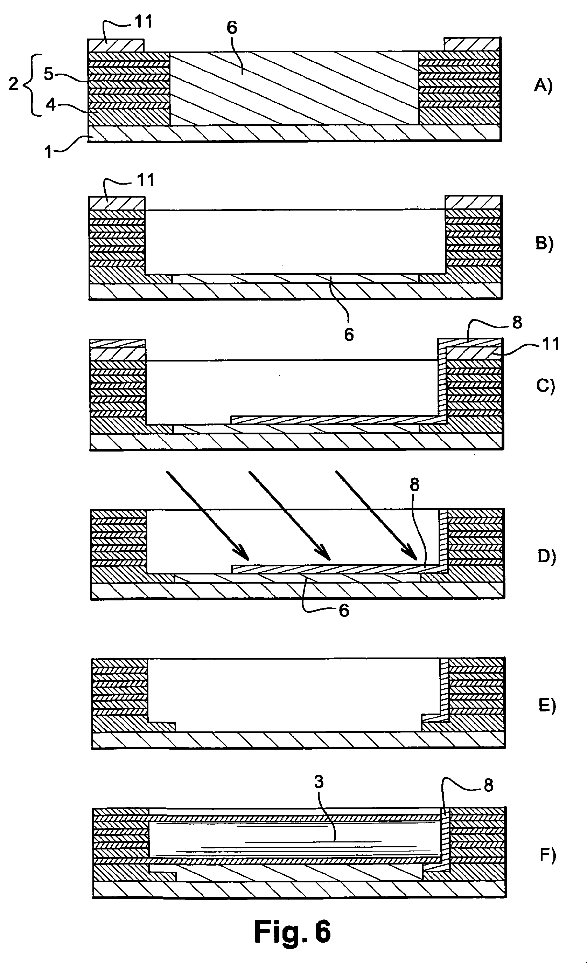

Le dépôt de ce matériau, avantageusement métallique, pour améliorer les contacts nanotubes/plots est illustré aux figures 4 et 6.

### BREVE DESCRIPTION DES FIGURES

La manière dont l'invention peut être réalisée et les avantages qui en découlent ressortiront mieux des exemples de réalisation qui suivent, donnés à titre indicatif et non limitatif, à l'appui des figures annexées parmi lesquelles :
La figure 1 schématise le principe d'interconnexion horizontale à base de CNT.
La figure 2 représente une vue en section des différentes étapes du procédé selon l'invention permettant de créer une connexion horizontale à base de CNT :
   A. Empilement comportant des plots multicouches et le diélectrique ;
   B. Ouverture de tranchées dans le diélectrique pour définir les connexions ;
   C. Dépôt optionnel d'un matériau pour améliorer le contact des nanotubes et de la structure ;
   D. Croissance des nanotubes entre les plots.
La figure 3 représente une vue de dessus des différentes étapes du procédé selon l'invention permettant de créer une connexion horizontale à base de CNT :
   A. Plots disposés suivant une matrice rectangulaire et noyés dans un diélectrique ;
   B. Ouverture de tranchées dans le diélectrique à l'endroit des futures connexions ;
   C. Dépôt optionnel d'un matériau pour améliorer les contacts ;
   D. Croissance des nanotubes entre les plots.
La figure 4 représente une vue en section des différentes étapes du procédé selon l'invention intégrant le recouvrement d'au moins une des faces du plot avec un métal assurant le contact nanotube/plot :
   A. Empilement avec des couches sacrificielles avant dépôt de résine pour définir les tranchées ;
   B. Ouverture de tranchées en s'arrêtant sur la couche sacrificielle du fond ;
   C. Dépôt sous incidence du métal de contact ne recouvrant qu'un des plots de la tranchée après élimination de la résine ;
   D. « Lift off» de la couche de métal de contact par élimination des couches sacrificielles ;
   E. Croissance des nanotubes avec auto-contact sur la couche de métal.

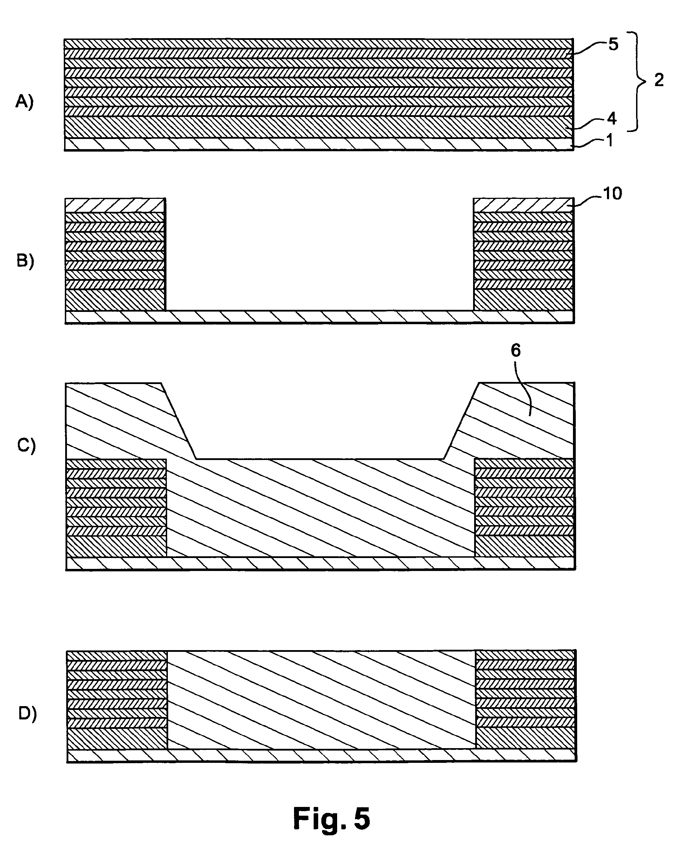

La figure 5 illustre les différentes étapes pour la réalisation d'un plot comprenant un empilement de couches :
   A. Dépôt du multicouche métal /diélectrique ;
   B. Définition des plots par lithographie ;
   C. Dépôt du second diélectrique ;
   D. Planarisation de la structure.
La figure 6 schématise une variante de la réalisation du procédé selon l'invention, sans sous-couche sacrificielle. Dans ce cas, le contrôle de la gravure permet de laisser une couche du matériau diélectrique qui joue alors le rôle de la couche sacrificielle de la Figure 4 :
   A. Dépôt de la résine pour définir les tranchées ;
   B. Gravure des tranchées et des motifs plots, en ménageant une fine couche de diélectrique ;
   C. Dépôt du métal de contact sous incidence parallèlement aux tranchées ;
   D. « Lift off » du métal de contact déposé sur la résine ;
   E. « Lift off » du métal de contact déposé sur la couche de diélectrique ;
   F. Croissance des nanotubes avec auto-contact sur la couche de métal.

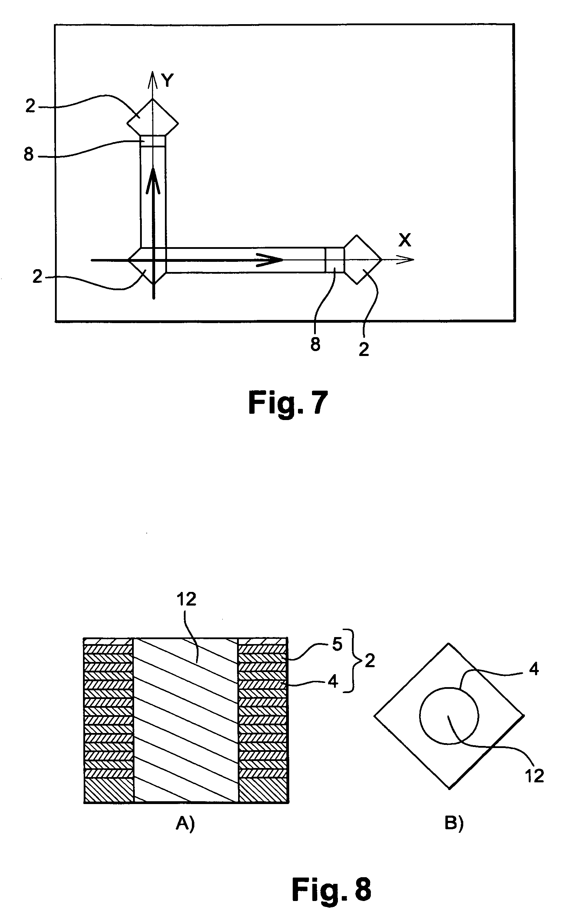

La figure 7 représente une vue de dessus des directions de dépôt en fonction de la direction des gorges.

La figure 8 est une vue en section (A) ou de dessus (B) d'un plot assurant une connexion verticale grâce à sa partie centrale remplie à l'aide d'un métal.

### EXEMPLES DE REALISATION DE L'INVENTION

### Exemple 1 :

Dans cet exemple, le diélectrique constituant le matériau espaceur des plots et celui noyant les plots sont identiques.

### 1/Réalisatiou de plots catalytiques noyés dans un diélectrique (Figure 5) :

- On dépose par IBS (« *ion beam sputtering* ») sur un substrat **1** qui peut être un composant électronique à connecter, un multicouche de vingt couches alumine (diélectrique = espaceur, **4**)/Fer (métal = catalyseur conducteur électrique, **5**) (Fig. 5A). L'épaisseur des couches est comprise entre 0,25 et 2 nanomètres.
- On dépose une résine **10** sur l'empilement ainsi constitué et on réalise la lithographie des plots de catalyseur **2**, soit en gravure sèche, soit en gravure humide, avec par exemple une solution d'H₃PO₄ qui attaque le fer et l'alumine (Fig. 5B).
- A noter que la première couche isolante de l'empilement, la dernière, ou les deux peuvent être plus épaisses que les couches isolantes du système catalytique.
- Une fois la gravure réalisée, on dépose de l'alumine (second diélectrique, **6**) par pulvérisation sur tout l'échantillon de façon à noyer les plots (Fig. 5C).
- On planarise le dépôt au moyen d'un polissage mécano-chimique (CMP) (Fig. 5D).

### 2/ Réalisation des tranchées 7 (Figure 6) :

- On étale une deuxième résine **11** sur tout l'échantillon, de façon à réaliser le motif de connexion souhaité (Fig. 6A).
- On ouvre le motif ainsi défini avec une solution d'H₃PO₄ ou par gravure plasma et on laisse subsister une épaisseur d'alumine **6** au fond des tranchées de l'ordre de 20 nanomètres (Fig. 6B).
- On dépose sous incidence rasante, par évaporation canon à électrons, une couche de palladium **8**, de 2 à 5 nanomètres d'épaisseur (Fig. 6C). L'échantillon ne tourne pas.
   Le plan d'incidence (comportant la normale à l'échantillon et la direction du flux incident) coupe le plan de l'échantillon selon l'une des directions des gorges (voir ci-dessous Figure 7).
- On effectue un deuxième dépôt identique en tournant l'échantillon de 90°.
- On réalise un « lift off » de la résine **11** (Fig. 6D).
- On réalise un « lift off » de la couche du second diélectrique **6** (Fig. 6E).
- On réalise la croissance des nanotubes **3** à une température comprise entre 400 et 650°C, au moyen d'acétylène dilué dans un mélange 50% hydrogène / 50% hélium. Les nanotubes **3** se connectent sur la surface en regard portant du palladium **8** (Fig. 6F).

La figure 7 montre, en vue de dessus, les dépôts réalisés à l'étape C dans deux directions perpendiculaires.

### Exemple 2 :

Le second diélectrique **6** servant à noyer les plots **2** est constitué de silice ou d'un matériau possédant une constante diélectrique faible (« low K ») voire très faible (« ultra low K »).

### Exemple 3 :

Les couches de métal catalyseur **5** sont réalisées au moyen d'un dépôt d'agrégats métalliques.

### Exemple 4 :

La couche servant d'espaceur **4** dans l'empilement catalytique est une couche de silicium.

### Exemple 5 :

On réalise des « vias » de connexion verticale au centre des plots de catalyseur. Cet exemple est schématisé à la figure 8. Un métal **12**, tel que le cuivre, traverse le plot **2** et assure une connexion verticale.

### REFERENCES

[1] Zhong et al., J. Phys. Chem. B (Letters), 2007, 111 (8) :1907-1910.
[2] Zhong et al., Carbon, 2006, 44 : 2009-2014.

## Revendications

1. Dispositif pour établir une connexion électrique horizontale entre au moins deux plots électriques (2), comprenant des nanotubes de carbone horizontaux (3) reliant les parois verticales desdits plots, lesdits plots étant réalisés à l'aide d'un empilement de couches d'au moins deux matériaux, l'un (5) catalysant la croissance des nanotubes et l'autre (4) jouant le rôle d'espaceur entre les couches de matériau catalysant la croissance des nanotubes.

2. Dispositif selon la revendication 1, ***caractérisé* en ce que** le matériau (5) catalysant la croissance des nanotubes est constitué sous la forme d'une couche continue ou sous la forme d'une couche composée d'agrégats.

3. Dispositif selon l'une des revendications 1 et 2, ***caractérisé* en ce que** le matériau catalyseur (5) est conducteur électrique, avantageusement un métal, notamment du fer, ou un alliage métallique.

4. Dispositif selon la revendication 3, ***caractérisé* en ce que** le matériau jouant le rôle d'espaceur (4) est un diélectrique, avantageusement un oxyde tel que l'alumine, la silice ou l'oxyde de magnésium.

5. Dispositif selon la revendication 3, ***caractérisé* en ce que** le matériau jouant le rôle d'espaceur (4) est conducteur électrique, avantageusement un semi-conducteur, tel que le silicium, ou un oxyde conducteur tel que l'oxyde d'indium dopé à l'étain ou l'oxyde de ruthénium.

6. Dispositif selon l'une des revendications 1 et 2, ***caractérisé* en ce que** le matériau catalyseur (5) est un diélectrique, avantageusement un oxyde de fer isolant, et **en ce que** le matériau jouant le rôle d'espaceur (4) est conducteur électrique, avantageusement un métal tel que le fer, le palladium et le titane, ou un oxyde conducteur tel que l'oxyde d'indium dopé à l'étain ou l'oxyde de ruthénium.

7. Dispositif selon l'une des revendications précédentes, ***caractérisé* en ce que** les plots (2) ont une section transversale en forme de losange.

8. Dispositif selon l'une des revendications précédentes, ***caractérisé* en ce qu'**au moins l'un des deux plots (2) à connecter est recouvert, au niveau de sa zone de contact avec les nanotubes de carbone (3), d'un matériau de contact (8), avantageusement du palladium.

9. Dispositif selon l'une des revendications précédentes, ***caractérisé* en ce que** les plots (2) contiennent une traversée verticale conductrice électrique (12), avantageusement réalisée à l'aide d'un métal tel que le cuivre.

10. Procédé de fabrication d'un dispositif de connexion horizontale selon l'une des revendications 1 à 9, comprenant les étapes suivantes :
- dépôt sur un substrat (1) d'un empilement de couches d'au moins deux matériaux, l'un (5) catalysant la croissance des nanotubes et l'autre (4) jouant le rôle d'espaceur entre les couches de matériau catalysant la croissance des nanotubes ;
- définition de plots (2) à partir de cet empilement ;
- immersion des plots (2) dans une matrice diélectrique (6), avantageusement constituée d'un oxyde, d'un nitrure ou d'un matériau à faible constante diélectrique ;
- formation de tranchées (7) dans la matrice isolante ;
- croissance des nanotubes de carbone dans les tranchées réalisant des connexions horizontales (3) entre les plots (2).

11. Procédé de fabrication d'un dispositif de connexion horizontale selon la revendication 10, ***caractérisé* en ce qu'**une couche de matériau conducteur électrique (8), tel que le palladium, est déposée sur au moins l'une des faces verticales des plots (2), avant la croissance des nanotubes.

## Claims

1. Device to establish a horizontal electrical connection between at least two bonding pads (2) which comprises horizontal carbon nanotubes (3) which link the vertical walls of said bonding pads, said bonding pads being produced by means of a stack of layers of at least two materials, one material (5) of which catalyzes growth of the nanotubes and the other material (4) of which acts as a spacer between the layers of material which catalyze growth of the nanotubes.

2. Device as claimed in claim 1, ***characterized* in that** material (5) which catalyzes growth of the nanotubes is in the form of a continuous layer or in the form of a layer comprising clusters.

3. Device as claimed in either claim 1 or 2, ***characterized* in that** the catalytic material (5) is electrically conductive and, advantageously, a metal, especially iron or a metal alloy.

4. Device as claimed in claim 3, ***characterized* in that** the material which acts as a spacer (4) is a dielectric and, advantageously, an oxide such as alumina, silica or magnesium oxide.

5. Device as claimed in claim 3, ***characterized* in that** the material which acts as a spacer (4) is electrically conductive and, advantageously, a semiconductor such as silicon or a conductive oxide such as tin-doped indium oxide or ruthenium oxide.

6. Device as claimed in either claim 1 or 2, ***characterized* in that** catalytic material (5) is a dielectric and, advantageously, an insulating iron oxide and **in that** the material which acts as a spacer (4) is electrically conductive and, advantageously, a material such as iron, palladium or titanium or a conductive oxide such as tin-doped indium oxide or ruthenium oxide.

7. Device as claimed in any of the above claims, ***characterized* in that** bonding pads (2) have a rhomboid cross-section.

8. Device as claimed in any of the above claims, ***characterized* in that** at least one of the two bonding pads (2) which are to be connected is covered, in the area in which it comes into contact with carbon nanotubes (3), with a contact material (8) which is advantageously palladium.

9. Device as claimed in any of the above claims, ***characterized* in that** bonding pads (2) contain an electrically conductive vertical feedthrough (12) which is advantageously made of a metal such as copper.

10. Method for fabricating a horizontal connection device in accordance with any of claims 1 to 9 comprising the following steps:
- deposit on substrate (1) a stack of layers of at least two materials, one (5) of which catalyzes growth of the nanotubes and the other (4) of which acts as a spacer between the layers of material which catalyzes growth of the nanotubes;
- define bonding pads (2) on the basis of this stack;
- embed bonding pads (2) in a dielectric matrix (6) which advantageously consists of an oxide or a nitride or a material which has a low dielectric constant;
- form channels (7) in the insulating matrix;
- grow the carbon nanotubes in the channels to produce horizontal connections (3) between the bonding pads (2).

11. Method for fabricating a horizontal connection device as claimed in claim 10, ***characterized* in that** a layer of electrically conductive material (8), such as palladium, is deposited on at least one of the vertical faces of bonding pads (2) before growing the nanotubes.

## Patentansprüche

1. Vorrichtung zum Herstellen einer horizontalen elektrischen Verbindung zwischen mindestens zwei elektrischen Kontaktstücken (2), horizontale Kohlenstoff-Nanoröhren (3) umfassend, die die vertikalen Wände der Kontaktstücke miteinander verbinden, wobei die Kontaktstücke mittels einer Stapelung von Schichten aus mindestens zwei Materialien hergestellt sind, wobei die eine Schicht (5) das Wachstum der Nanoröhren katalysiert, und die andere Schicht (4) die Rolle eines Abstandhalters zwischen den Schichten aus dem, das Wachstum der Nanoröhren katalysierenden, Material spielt.

2. Vorrichtung nach Anspruch 1, **dadurch gekennzeichnet, dass** das das Wachstum der Nanoröhren katalysierende Material (5) sich in Form einer durchgehenden Schicht oder in Form einer aus Aggregaten zusammengesetzten Schicht darstellt.

3. Vorrichtung nach einem der Ansprüche 1 und 2, **dadurch gekennzeichnet, dass** das Katalysatormaterial (5) ein elektrischer Leiter, vorteilhafter Weise ein Metall, insbesondere Eisen, oder eine Metalllegierung ist.

4. Vorrichtung nach Anspruch 3, **dadurch gekennzeichnet, dass** das die Abstandhalterrolle spielende Material (4) ein Dielektrikum, vorzugsweise ein Oxid, wie etwa Aluminiumoxid, Siliciumoxid oder Magnesiumoxid, ist.

5. Vorrichtung nach Anspruch 3, **dadurch gekennzeichnet, dass** das die Abstandhalterrolle spielende Material (4) ein elektrischer Leiter, vorteilhafter Weise ein Halbleiter wie etwa Silicium, oder ein leitfähiges Oxid, wie etwa Indiumoxid, das mit Zinn dotiert ist, oder Rutheniumoxid, ist.

6. Vorrichtung nach einem der Ansprüche 1 und 2, **dadurch gekennzeichnet, dass** das Katalysatormaterial (5) ein Dielektrikum, vorteilhafter Weise ein isolierendes Eisenoxid ist, und dass das die Abstandhalterrolle spielende Material (4) ein elektrischer Leiter, vorteilhafter Weise ein Metall, wie Eisen, Palladium, Titan oder ein leitfähiges Oxid, wie etwa Indiumoxid, das mit Zinn dotiert ist, oder Rutheniumoxid, ist.

7. Vorrichtung nach einem der vorhergehenden Ansprüche, **dadurch gekennzeichnet, dass** die Kontaktstücke (2) einen rautenförmigen Querschnitt haben.

8. Vorrichtung nach einem der vorhergehenden Ansprüche, **dadurch gekennzeichnet, dass** mindestens eines der beiden zu verbindenden Kontaktstücke (2) im Bereich seiner Kontaktzone mit den Kohlenstoff-Nanoröhren (3) mit einem Kontaktmaterial (8), vorteilhafter Weise Palladium, bedeckt ist.

9. Vorrichtung nach einem der vorhergehenden Ansprüche, **dadurch gekennzeichnet, dass** die Kontaktstücke (2) einen elektrisch leitenden vertikalen Durchgang (12) enthalten, der vorteilhafter Weise mittels eines Metalls, wie etwa Kupfer, hergestellt ist.

10. Verfahren zur Herstellung einer Horizontalverbindungsvorrichtung nach einem der Ansprüche 1 bis 9, die folgenden Schritte umfassend:
- Abscheiden, einer Stapelung von Schichten aus mindestens zwei Materialien auf einem Substrat (1), wobei die eine Schicht (5) das Wachstum von Nanoröhren katalysiert, und die andere Schicht (4) die Rolle eines Abstandhalters zwischen den Schichten aus dem, das Wachstum der Nanoröhren katalysierenden, Material spielt;
- Definieren von Kontaktstücken (2) ausgehend von dieser Stapelung;
- Eintauchen der Kontaktstücke (2) in eine dielektrische Matrix (6) die vorteilhafter Weise aus einem Oxid, einem Nitrid oder einem Material mit geringer Dielektrizitätskonstante besteht;
- Ausbilden von Gräben (7) in der isolierenden Matrix;
- Einwachsenlassen der Kohlenstoff-Nanoröhren in die Gräben unter Ausbildung horizontaler Verbindungen (3) zwischen den Kontaktstücken (2).

11. Verfahren zur Herstellung einer Horizontalverbindungsvorrichtung nach Anspruch 10, **dadurch gekennzeichnet, dass** eine Schicht (8) aus elektrisch leitfähigem Material, wie etwa Palladium, vor dem Wachstum der Nanoröhren auf mindestens einer der vertikalen Flächen der Kontaktstücke (2) abgeschieden wird.
